(19) Europäisches Patentamt
European Patent Office
Office européen des brevets

(11) Veröffentlichungsnummer : **0 201 508**
**B1**

(12) # EUROPÄISCHE PATENTSCHRIFT

(45) Veröffentlichungstag der Patentschrift : **30.11.88**

(51) Int. Cl.⁴ : **C 23 C 14/14**// G04B37/00, A44C27/00

(21) Anmeldenummer : **85903269.0**

(22) Anmeldetag : **03.07.85**

(86) Internationale Anmeldenummer : **PCT/EP 85/00318**

(87) Internationale Veröffentlichungsnummer : **WO/8600650 (30.01.86 Gazette 86/03)**

(54) **VERFAHREN ZUR HERSTELLUNG VON GOLDFARBENEN TITANNITRID-SCHICHTEN.**

(30) Priorität : **11.07.84 DE 3425468**

(43) Veröffentlichungstag der Anmeldung : **20.11.86 Patentblatt 86/47**

(45) Bekanntmachung des Hinweises auf die Patenterteilung : **30.11.88 Patentblatt 88/48**

(84) Benannte Vertragsstaaten : **AT CH DE FR GB IT LI**

(56) Entgegenhaltungen :
**EP-A- 0 038 294**
**EP-A- 0 087 151**
**GB-A- 1 096 925**
**GB-A- 2 117 009**
**US-A- 3 767 026**
**Metalloberfläche, vol. 27, no. 7, July 1983, (DE), W.D. Münz: "Herstellung harter dekorativer goldfarbener Titannitridschichten mittels Hochleistungskatodenzerstäubung", pp. 279-285**
**IBM Technical Disclosure Bulletin, vol. 21, no. 9, February 1979, New York (US), C.B. ZAROWIN: "Roomtemperature, plasma chemical transportdeposition of metal (gold) films", p. 3832**
**C.F. POWELL: "Vapor deposition", publ. in 1966, J. Wiley, New York (US), pp. 298-299**

(73) Patentinhaber : **Battelle-Institut e.V.**
**Am Römerhof 35 Postfach 900 160**
**D-6000 Frankfurt/Main 90 (DE)**

(72) Erfinder : **STEININGER, Helmut**
**Schumannstrasse 12**
**D-6392 Neu-Anspach (DE)**
Erfinder : **ETZKORN, Heinz-Werner**
**Schumannstrasse 16**
**D-6392 Neu-Anspach (DE)**

(74) Vertreter : **Sartorius, Peter, Dipl.-Ing.**
**Battelle-Institut e.V. Abteilung Patente Am Römerhof 35**
**D-6000 Frankfurt am Main 90 (DE)**

Anmerkung : Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**EP 0 201 508 B1**

Jouve, 18, rue St-Denis, 75001 Paris, France

**Beschreibung**

Die Erfindung betrifft ein Verfahren zur Herstellung von goldfarbenen Titannitrid-Schichten durch Einlagerung von Gold mittels plasmagestützter Beschichtungsmethoden, insbesondere mittels Magnetronsputtern, unter Verwendung eines Prozeßgases aus einem Edelgas und Stickstoff.

Mit physikalischen Beschichtungsverfahren wie Magnetronsputtern (Hochratesputtern), Ion-Plattierung usw. können goldfarbene Titannitrid-Schichten auf beliebigen Substraten hergestellt werden, die vom Farbeindruck reinen Goldschichten ähnlich sind. Aufgrund ihrer geringen Brillianz, eines etwas zu kleinen Gelbwertes und geringen Rotanteilen lassen sich reine Titannitrid-Schichten jedoch optisch von reinen Goldschichten unterscheiden. Diesem Mangel stehen andererseits die hervorragenden physikalischen und chemischen Eigenschaften der Titannitrid-Schichten, wie große Härte und ausgezeichnete Korrosionsbeständigkeit gegenüber. Insbesondere die sich aus der hohen Härte ergebende Kratzfestigkeit von Titannitrid-Schichten sind den reinen Goldschichten deutlich überlegen, was ihren hohen Gebrauchswert bei dekorativen Anwendungen ausmacht.

Es ist bekannt, Gold in Titannitrid-Schichten einzubringen. Dabei wird z. B. von einem Gold enthaltenden Titan-Target bzw. einem Target aus einer Titan/Gold-Legierung ausgegangen. Eine andere Möglichkeit ist die Verwendung eines Verbund-Targets aus Titannitrid und Gold, wie beschrieben in EP-A-0038294. Die durch diese Methoden erhaltenen Titannitrid-Schichten haben einen durch die ganze Schicht homogenen Goldanteil. Dies führt einerseits zu einer wesentlichen Verteuerung und andererseits zu einer erheblichen Minderung der Schichthärte und damit der Kratzfestigkeit.

Der Erfindung liegt die Aufgabe zugrunde, die optischen Unterscheidungsmerkmale zwischen Titannitrid- und Gold-Schichten zu reduzieren. Dabei sollte die große Härte und ausgezeichnete Korrosionsbeständigkeit von Titannitrid nicht beeinträchtigt werden.

Diese Aufgabe ist erfindungsgemäß dadurch gelöst, daß während der Abscheidung des Titannitrids dem Prozeßgas eine leichtflüchtige Goldverbindung beigemischt wird. Bevorzugte Ausführungsformen des erfindungsgemäßen Verfahrens sind in den Unteransprüchen 2 bis 5 beschrieben.

Erfindungsgemäß erfolgt die Abscheidung der Titannitrid-Schicht durch Magnetronsputtern. Gold wird während der Titannitrid-Abscheidung in die aufwachsende Schicht eingelagert. Zu diesem Zweck wird zusätzlich zu den bekannten Prozeßgasen Edelgas, vorzugsweise Argon, und Stickstoff, Gold enthaltende, leichtflüchtige Verbindungen in die Beschichtungsanlage eingelassen. Die Durchflußmenge des Argons beträgt 10 bis 30, vorzugsweise 13 bis 14 $cm^3$/Min, die des Stickstoffs 2 bis 10, vorzugsweise 2 bis 3 $cm^3$/Min. Im zwischen Target und Substrat brennenden Plasma werden die Moleküle der Goldverbindung ionisiert, angeregt und gecrackt. Dabei freigesetztes Gold oder Gold enthaltende Molekülfragmente schlagen sich auf dem Substrat nieder, die aus beliebigen Materialien wie Kunststoff, reine Metalle oder Legierungen bestehen kann. Dort werden sie direkt oder nach weiterer Umwandlung durch ioneninduzierte Vorgänge in die stetig aufwachsende Schicht eingebaut. Der Goldgehalt und damit letztlich auch der Farbeindruck der Titannitrid-Schicht wird über die Durchflußmenge der goldenthaltenden leichtflüchtigen Komponente bestimmt. Die Durchflußmenge an Goldverbindung beträgt vorzugsweise 2 bis 10 $cm^3$/Min. Bei konstanter Durchflußmenge entstehen Titannitrid-Schichten, die Gold homogen über die gesamte Schichtdicke verteilt enthalten. Durch definierte zeitliche Änderungen der Durchflußmenge der Gold enthaltenden Verbindung können Titannitrid-Schichten mit beliebigem Gold-Konzentrationsgradienten eingestellt werden. Im besonderen ist es mit dem erfindungsgemäßen Verfahren möglich, Schmuck mit Gold im Sinne der DIN 58 682 gegebenen Definition zu plattieren. Zur Durchführung des erfindungsgemäßen Verfahrens sind insbesondere Organophosphin- oder Organoarsin-Derivate von Goldhalogeniden geeignet. Besonders bevorzugt sind Organophosphin-Derivate der Formel

$$R_3P,\ AuHal$$

in der R eine Alkylgruppe mit 1 bis 6, vorzugsweise 2 bis 4 C-Atomen und Hal Chlor oder Jod bedeuten, insbesondere Chlortriethylphosphin-Gold $(C_2H_5)_3P$, AuCl, Jodtriethylphosphin-Gold $(C_2H_5)_3P$, AuJ, Chlortripropylphosphin-Gold $(C_3H_7)_3P$, AuCl, Chlortributylphosphin-Gold $(C_4H_9)_3P$, AuCl und Jodtributylphosphin-Gold $(C_4H_9)_3$, AuJ. Solche Verbindungen besitzen Schmelzpunkte bis zu ca. 90 °C oder sie sind bereits bei Raumtemperatur flüssig.

Die Erfindung wird anhand des nachfolgenden Beispiels näher erläutert :

Beispiel

Ein Werkstück aus Edelstahl wird in anorganischen und/oder organischen Lösungsmitteln, vorzugsweise im Ultraschallbad, vorgereinigt und in einer üblichen Beschichtungsapparatur durch Sputterätzen einer Endreinigung unterzogen. Dem Reinigungsprozeß schließt sich die Beschichtung durch an sich bekanntes reaktives Magnetronsputtern an. In die Vakuumapparatur wird Argon und Stickstoff eingelassen. Die Durchflußmenge für Argon beträgt 13,5 $cm^3$/Min, für Stickstoff 2,5 $cm^3$/Min. Zu den beiden Gasen wird etwa ab der Mitte der gesamten Beschichtungszeit Chlortriethylphosphin-Gold eingeleitet. Die Durchflußmenge der Goldverbindung steigt dann

kontinuierlich auf ca. 5 $cm^3$/Min. Es wird eine harte, goldhaltige Titannitrid-Schicht erhalten, deren optischer Eindruck demjenigen reiner Goldschichten entspricht.

## Patentansprüche

1. Verfahren zur Herstellung von goldfarbenen Titannitrid-Schichten durch Einlagerung von Gold mittels plasmagestützter Beschichtungsmethoden, insbesondere mittels Magnetronsputtern, unter Verwendung eines Prozeßgases aus einem Edelgas und Stickstoff, dadurch gekennzeichnet, daß während der Abscheidung des Titannitrids dem Prozeßgas eine leichtflüchtige Goldverbindung beigemischt wird.

2. Verfahren nach Anspruch 1, dadurch gekennzeichnet, daß die Durchflußmenge der flüchtigen Goldverbindung während der Abscheidung des Titannitrids kontinuierlich gesteigert wird.

3. Verfahren nach Anspruch 1, dadurch gekennzeichnet, daß die Beimischung der flüchtigen Goldverbindung zum Prozeßgas kurz vor der Beendigung des Abscheidevorgangs erfolgt.

4. Verfahren nach einem der Ansprüche 1 bis 3, dadurch gekennzeichnet, daß die Durchflußmenge der flüchtigen Goldverbindung 2 bis 10 $cm^3$/Min beträgt.

5. Verfahren nach einem der Ansprüche 1 bis 4, dadurch gekennzeichnet, daß die Durchflußmenge des Edelgases, vorzugsweise Argons 10 bis 30 $cm^3$/Min, vorzugsweise 13 bis 14 $cm^3$/Min und des Stickstoffs 2 bis 10 $cm^3$/Min, vorzugsweise 2 bis 3 $cm^3$/Min, beträgt.

6. Verfahren nach einem der Ansprüche 1 bis 5, dadurch gekennzeichnet, daß als Goldverbindung Organophosphin- oder Organoarsin-Derivate von Goldhalogeniden verwendet werden.

7. Verfahren nach Anspruch 6, dadurch gekennzeichnet, daß als Organophosphin-Derivate von Goldhalogeniden Verbindungen der Formel

$$R_3P, AuHal$$

verwendet werden, in der R eine Alkylgruppe mit 1 bis 6, vorzugsweise 2 bis 4 C-Atomen und Hal Chlor oder Jod bedeuten.

## Claims

1. Method of producing gold-coloured titanium nitride coatings by incorporating gold by means of plasma-assisted coating methods, in particular by means of magnetron sputtering, using a process gas consisting of a noble gas and nitrogen, comprising : admixing a readily volatile gold compound to the process gas during the deposition of the titanium nitride.

2. Method as claimed in Claim 1, wherein the flow rate of the volatile gold compound is continuously raised during the deposition of the titanium nitride.

3. Method as claimed in Claim 1, wherein the volatile gold compound is admixed to the process gas shortly before the end of the deposition process.

4. Method as claimed in any of the Claims 1 to 3, wherein the flow rate of the volatile gold compound is 2 to 10 $cm^3$/min.

5. Method as claimed in any of the Claims 1 to 4, wherein the flow rate of the noble gas, preferably argon, is 10 to 30 $cm^3$/min, preferably 13 to 14 $cm^3$/min, and the flow rate of nitrogen is 2 to 10 $cm^3$/min, preferably 2 to 3 $cm^3$/min.

6. Method as claimed in any of the Claims 1 to 5, wherein organophosphine or organoarsine derivatives of gold halides are used as gold compound.

7. Method as claimed in Claim 6, wherein compounds of the formula

$$R_3P, AuHal$$

where R is an alkyl group with 1 to 6, preferably 2 to 4 C atoms, and Hal means chlorine or iodine, are used as organophosphine derivatives of gold halides.

## Revendications

1. Procédé de préparation de couches de nitrure de titane de couleur, ou par inclusion d'or au moyen de procédés de revêtement par plasma, notamment par pulvérisation au magnétron, en utilisant un gaz de processus constitué d'un gaz rare et d'azote, caractérisé en ce que pendant le dépôt de nitrure de titane on ajoute et mélange au gaz de procédé, un composé volatil d'or.

2. Procédé selon la revendication 1, caractérisé en ce que le débit de composé volatil d'or est augmenté en permanence pendant le dépôt de nitrure de titane.

3. Procédé selon la revendication 1, caractérisé en ce que le mélange du composé volatil d'or au gaz de procédé a lieu peu de temps avant la fin du processus de dépôt.

4. Procédé selon l'une des revendications 1 à 3, caractérisé en ce que le débit du composé d'or volatil est de 2 à 10 $cm^3$/min.

5. Procédé selon l'une des revendications 1 à 4, caractérisé en ce que le débit de gaz est de 10 à 30 $cm^3$/min. et celui de l'azote de 2 à 10 $cm^3$/min.

6. Procédé selon l'une des revendications 1 à 5, caractérisé en ce qu'on utilise comme composé d'or des dérivés organophosphine ou organoarsine d'halogénure d'or.

7. Procédé selon la revendication 6, caractérisé en ce qu'on utilise comme dérivé organophosphine d'halogénures d'or des composés de formule

$$R_3P, AuHal$$

dans laquelle R est un groupe alkyle avec 1 à 6, de préférence 2 à 4 atomes de C et Hal est le chlore ou l'iode.